# EUROPÄISCHE PATENTANMELDUNG

(11) **EP 0 691 626 A2**
(43) Veröffentlichungstag der Anmeldung: **10.01.1996**
(21) Anmeldenummer: 95109745.0
(22) Anmeldetag: 22.06.1995
(51) Int. Cl.: G06K 19/077

(54) **Datenträger mit einem Modul mit integriertem Schaltkreis**

(30) Priorität: 05.07.1994 DE 4423575
(71) Anmelder: Giesecke & Devrient GmbH, D-81677 München (DE)
(72) Erfinder: Haghiri, Yahya, D-80797 München (DE); Barak, Renée Lucia, D-82008 Unterhaching (DE)
(74) Vertreter: Klunker . Schmitt-Nilson . Hirsch

(57) **Zusammenfassung**

Es wird ein Datenträger vorgestellt mit einem Modul mit integriertem Schaltkreis, der leitend mit Kopplungselementen verbunden ist, wobei der Schaltkreis und die leitenden Verbindungen von einer Gußmasse umgeben sind. Um die relativ langen Aushärtezeiten bei herkömmlichen Gußmassen zu verkürzen wird vorgeschlagen, elektronenstrahlhärtende Vergußmasse verwenden.

## Beschreibung

Die Erfindung betrifft einen Datenträger mit einem Modul mit integriertem Schaltkreis, der leitend mit Kopplungselementen verbunden ist, wobei der Schaltkreis und die leitenden Verbindungen von einer Gußmasse umgeben sind.

Datenträger mit Modulen mit integriertem Schaltkreis sind seit langem bekannt und können beispielsweise als Ausweiskarte, Bankkarte, Telefonkarte etc. verwendet werden.

Die Module verfügen über Kopplungselemente für den Datenaustausch mit externen Geräten, einen integrierten Schaltkreis und leitende Verbindungen, die den Schaltkreis mit den Kopplungselementen verbinden. Die Kopplungselsmente können z. B. als Kontaktflächen für die berührende Kontaktaufnahme ausgebildet sein. Die empfindlichen Bestandteile des elektronischen Moduls sind im allgemeinen zum Schutz vor mechanischen Belastungen mit einer Gußmasse vergossen.

So ist beispielsweise aus der DE 37 23 547 ein elektronisches Modul bekannt, das über einen Trägerfilm verfügt, auf dessen einer Oberfläche Kontaktflächen liegen. In dem Trägerfilm sind Fenster vorgesehen, die den integrierten Schaltkreis aufnehmen und eine Führung der leitenden Verbindungen vom Schaltkreis zu den Kontaktflächen ermöglichen. Auf der den Kontaktflächen gegenüberliegenden Seite des Trägerfilms ist eine Heißkleberschicht aufgebracht, die ebenfalls über ein Fenster verfügt, das den Schaltkreis und die leitenden Verbindungen aufnimmt. Schaltkreis und leitende Verbindungen werden mit einer aushärtbaren Vergußmasse vergossen, wobei der Rand des Fensters in der Heißkleberschicht als Begrenzungsrahmen für die Gußmasse dient. Das Modul wird mit Hilfe der Heißklebeschicht in eine entsprechend angepaßte Kartenaussparung eingesetzt und in dieser mit dem Kartenkörper verbunden.

Die Aushärtung der Gußmasse kann entweder thermisch oder durch Bestrahlung mit UV-Licht erfolgen. Entsprechende Zusammensetzungen für thermisch aushärtende Vergußmassen können der GB 2,086,134 entnommen werden, Zusammensetzungen für UV-aushärtende Gußmassen der EP 0 386 473.

Es ist auch bekannt, in der Aussparung einer Karte zunächst eine entsprechende Guß- bzw. Klebemasse zu dosieren, in die dann ein Modul ohne Vergußmasse eingesetzt wird. Nach dem Aushärten der Gußmasse ist das Modul fest mit dem Kartenkörper verbunden.

Bei den bisher bekannt gewordenen Lösungen nimmt die Aushärtung der Gußmasse noch eine relativ lange Zeit in Anspruch.

Der Erfindung liegt deshalb die Aufgabe zugrunde, einen Datenträger mit elektronischem Modul vorzustellen, bei dem die empfindlichen Bauteile optimal vor mechanischen Belastungen geschützt werden, der aber rationeller und damit kostengünstiger herstellbar ist.

Die Aufgabe wird durch die Merkmale des Hauptanspruchs gelöst.

Die Erfindung ist im wesentlichen dadurch gekennzeichnet, daß die aie zu schützenden Komponenten des elektronischen Moduls umgebende Guß- oder Klebemasse ein mit Elektronenstrahlen härtbares Material ist.

Die Vorteile der Erfindung sind insbesondere darin zu sehen, daß eine elektronenstrahlhärtende Vergußmasse extrem schnell aushärtet und die Vergußmasse, beispielsweise bei großen Schaltkreisen, auch großvolumig aufgebracht und dennoch schnell verarbeitet werden kann. Durch die schnelle Verarbeitung kann die Fertigstellung der Module bzw. Karten pro Zeiteinheit erhöht und somit der Kartenpreis gesenkt werden. Darüber hinaus benötigen elektronenstrahlhärtende Vergußmassen keine korrosionsfördernden Fotoinitiatoren, die in UV-aushärtenden Vergußmassen vonnöten sind. Somit sind insbesondere die leitenden Verbindungen des Moduls besser vor Korrosion geschützt.

Gemäß einer ersten Ausführungsform wird in die für das Modul vorgesehene Aussparung des Kartenkörpers die elektronenstrahlhärtende Vergußmasse eingefüllt. Das Modul, das in diesem Fall keine Vergußmasse aufweisen muß, wird daraufhin in die Karte eingesetzt. Zum Aushärten wird die Vergußmasse, beispielsweise durch die Kartenrückseite, mit Elektronenstrahlen gehärtet.

In einer zweiten Ausführungsform kann das elektronische Modul gefertigt werden, wie es z. B. an sich aus der DE 37 23 547 bekannt ist. Hierbei findet in einem Verfahrensschritt die Aushärtung der Gußmasse jedoch mit Hilfe von Elektronenstrahlen statt. Das fertige Modul wird über einen Heißklebering in die Aussparung des Kartenkörpers eingeklebt.

In einer dritten Ausführungsform kann die Gußmasse mit Hilfe einer Gußform auf das elektronische Modul aufgebracht werden, wie es auch an sich bekannt ist. Die Aushärtung der Gußmasse findet durch die Gußform hindurch statt, die für Elektronenstrahlen durchlässig sein muß. Der Angußkanal der Gußform besteht hierbei aus elektronenstrahlabsorbierendem Material. Dadurch wird verhindert, daß sich beim Aushärten Material auch im Angußkanal verfestigt und diesen dann verstopft. Das fertige Modul wird ebenfalls über einen Heißklebering in den Kartenkörper eingeklebt.

Die eben beschriebene Ausführungsform kann vorteilhaft auch auf UV-aushärtende Gußmassen übertragen werden. Die Gußform besteht dann aus UV-strahlendurchlässigem Material, während der Angußkanal UV-strahlenabsorbierend ausgeführt ist. Die Aushärtung erfolgt über UV-Strahlen.

Weitere Vorteile und Weiterbildungen der Erfindung ergeben sich aus den Unteransprüchen, die nachfolgend anhand der Figuren beschrieben werden. Darin zeigt:
- Fig. 1: eine Ausweiskarte mit einem eingelagerten elektronischen Modul in der Aufsicht
- Fig. 2: eine Ausweiskarte nach Fig. 1 im Schnitt
- Fig. 3: ein elektronisches Modul über Heißklebering in Ausweiskarte befestigt
- Fig. 4: ein elektronisches Modul mit einer aufgesetzten Gußform.

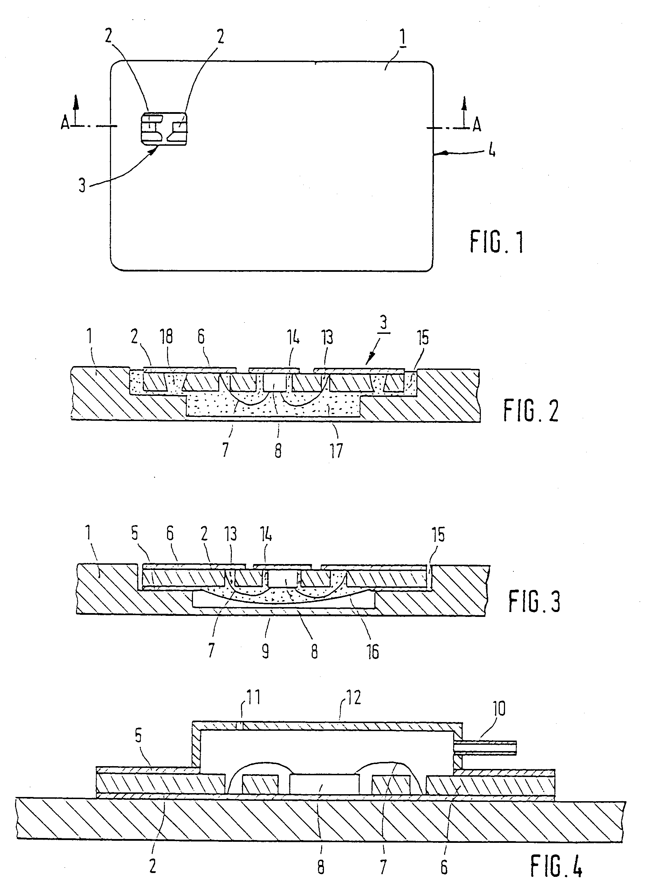

Die Fig. 1 zeigt eine Ausweiskarte 4, in der ein elektronisches Modul 3 verklebt ist.

Die Fig. 2 zeigt einen Schnitt der Karte aus Fig. 1 entlang der Linie A-A. Das elektronische Modul 3 ist hierbei über die elektronenstrahlhärtende Vergußmasse 17 in die Aussparung 15 des Kartenkörpers 1 geklebt. Das elektronische Modul 3 besteht aus dem Trägerfilm 6, auf dem sich die Kontaktflächen 2 befinden. Der Trägerfilm 6 besitzt Fenster 13 und 14 zur Aufnahme des integrierten Schaltkreises 8 und zur Durchführung der Bonddrähtchen 7. Der integrierte Schaltkreis 8 ist über einen Kleber mit der Kontaktfläche 2 verbunden. Darüber hinaus verbinden die Bonddrähtchen 7 den integrierten Schaltkreis 8 mit den Kontaktflächen 2. Um das elektronische Modul 3 besser in der Aussparung 15 des Kartenkörpers 1 verankern zu können, lassen sich verschiedene Maßnahmen vornehmen:
- Aufrauhen der Oberfläche der Aussparung 15 und/oder des Trägerfilms 6,
- Maßnahmen zur Verbesserung der Verankerung am Träger, wie z. B. ein konisch zulaufendes Fenster 18 im Trägerfilm 6 und/oder durch besondere Formgebung der Aussparung.

Das elektronische Modul 3 wird, wie folgt beschrieben, mit der Aussparung 15 des Kartenkörpers 1 verbunden:
- In einem ersten Schritt wird eine dosierte Menge an elektronenstrahlhärtender Vergußmasse in die Aussparung 15 des Kartenkörpers 1 eingebracht.
- In einem zweiten Schritt wird das elektronische Modul 3 in dieselbe Aussparung 15 eingedrückt, so daß sich die elektronenstrahlhärtende Vergußmasse 17 gleichmäßig über den noch verbleibenden Raum verteilt.
- In einem letzten Schritt wird die elektronenstrahlhärtende Vergußmasse 17 durch die Einwirkung von Elektronenstrahlen z. B. von der Kartenrückseite her ausgehärtet.

Die Fig. 3 zeigt eine zweite Ausführungsform eines erfindungsgemäßen Datenträgers mit Modul. Das elektronische Modul 3 entspricht dem aus der DE 37 23 547 bekannten Modul und ist über einen Heißkleber 5 in die Aussparung 15 des Kartenkörpers 1 geklebt. Der Aufbau des Moduls wird hier nicht näher erläutert, da er weitestgehend mit dem in Fig. 2 gezeigten übereinstimmt. Der integrierte Schaltkreis 8 sowie die Bonddrähtchen 7 sind erfindungsgemäß mit einer elektronenstrahlhärtenden Vergußmasse vergossen. In diesem speziellen Ausführungsbeispiel wurde die elektronenstrahlhärtende Vergußmasse in Form eines Tropfens aufgebracht und darauffolgend mit einem Elektronenstrahl ausgehärtet.

Bei dem in der Fig. 3 gezeigten Modul wird die Gußmasse, wie bereits gesagt, in Form eines Tropfens aufgebracht, dessen Form nicht genau reproduzierbar ist. Aus diesem Grunde muß die Aussparung in dem Kartenkörper so ausgebildet sein, daß Abweichungen in der Form des Tropfens kompensiert werden können. Für den Fall, daß eine hohe Reproduzierbarkeit der äußeren Form des elektronischen Moduls notwendig ist, bietet es sich an, den Verguß des Moduls mit Hilfe einer Gußform zu erstellen. Eine entsprechende Ausführungsform ist in Fig. 4 gezeigt.

Dabei wird eine elektronenstrahldurchlässige Gußform 12 bündig auf den inneren Rand der Heißkleberfolie 5 aufgesetzt und der gesamte Innenraum über den elektronenstrahlabsorbierenden Angußkanal 10 mit elektronenstrahlhärtender Vergußmasse befüllt. Das dabei verdrängte Luftvolumen kann über den Entlüftungskanal 11 entweichen. Nachdem der gesamte Innenraum mit elektronenstrahlhärtender Vergußmasse aufgefüllt ist, wird diese durch Elektronenstrahlen ausgehärtet, wobei das Material im elektronenstrahlabsorbierenden Angußkanal 10 flüssig bleibt. Hierdurch wird verhindert, daß ausgehärtete Vergußmasse den Angußkanal verstopft. Danach wird die Gußform abgenommen. Anstatt der geschlossenen Gußform kann auch ein Gußring verwendet werden, was den Vorteil hat, daß die Elektronenstrahlen nicht durch den Deckel der Gußform abgeschwächt werden.

Der Verguß des Moduls mit einer der eben beschriebenen Vergußform kann auch vorteilhaft auf UV-aushärtende Vergußmassen übertragen werden. Die Gußform 12 ist hierbei aus UV-strahlendurchlässigem Material gefertigt, während der Angußkanal 10 UV-strahlenabsorbierend ist. Die Gußform 12 wird hierbei in analoger Weise mit UV-aushärtender Vergußmasse befüllt und über UV-Strahlen ausgehärtet.

Selbstverständlich ist die Verwendung von elektronenstrahlhärtenden Vergußmassen nicht auf die in den Figuren gezeigten Module beschränkt. Vielmehr können alle Module weiterhin verwendet werden, die bereits aus dem Stand der Technik bekannt sind, wie beispielsweise Lead-Frame Module oder aber kontaktlose Module, bei denen die Kontaktelemente induktive, kapazitive oder optische Elemente bilden. Diese Module sind dem Fachmann geläufig und sollen hier nicht näher erläutert werden. Darüber hinaus ist der Einbau der in den Fig. 2 und 3 gezeigten Module in den Kartenkörper ebenfalls nicht auf das Einkleben über einen Heißklebering in eine Aussparung des Kartenkörpers beschränkt. Natürlich können auch andere Verfahren verwandt werden, die dem Fachmann hinlänglich bekannt sind, wie beispielsweise die Montagetechnik mit einem Flüssigkleber, die Laminiertechnik oder die Spritzgußtechnik.

## Patentansprüche

1. Datenträger mit einem in einer Aussparung angeordneten Modul mit integriertem Schaltkreis, der leitend mit Kopplungselementen verbunden ist, wobei der integrierte Schaltkreis und die leitenden Verbindungen im Bereich der Aussparung von einer Vergußmasse umgeben sind, dadurch **gekennzeichnet,** daß die Vergußmasse eine elektronenstrahlhärtende Vergußmasse ist.

2. Datenträger gemäß Anspruch 1, dadurch **gekennzeichnet,** daß die elektronenstrahlhärtende Vergußmasse die Aussparung im Datenträger ausfüllt und das Modul mit dem Datenträger verbindet.

3. Datenträger gemäß Anspruch 1, dadurch **gekennzeichnet,** daß die Vergußmasse nur einen Teil der Aussparung ausfüllt und ein Heißkleber den Datenträger mit dem Modul verbindet.

4. Elektronisches Modul für den Einbau in einen Datenträger, das einen integrierten Schaltkreis, der leitend mit Kopplungselementen verbunden ist, aufweist, wobei der integrierte Schaltkreis und die leitenden Verbindungen von einer Vergußmasse umgossen sind, dadurch **gekennzeichnet,** daß die Vergußmasse eine elektronenstrahlhärtende Vergußmasse ist.

5. Elektronisches Modul gemäß Anspruch 4, dadurch **gekennzeichnet,** daß die elektronenstrahlhärtende Vergußmasse eine zylindrische oder rechteckige Form aufweist.

6. Verfahren zum Einbringen eines elektrischen Moduls, bestehend aus Kontaktelementen und einem integrierten Schaltkreis, der leitend mit den Kontaktelementen verbunden ist, **gekennzeichnet** durch folgende Verfahrensschritte,
- dosiertes Füllen der Aussparung eines Datenträgers mit elektronenstrahlhärtender Vergußmasse,
- Einsetzen des Moduls in die Aussparung,
- Aushärten der Vergußmasse durch Elektronenstrahlen.

7. Verfahren zum Vergießen eines elektronischen Moduls, bestehend aus Kontaktelementen, einem integrierten Schaltkreis, der leitend mit den Kontaktelementen verbunden ist, sowie einer Vergußmasse, die den integrierten Schaltkreis und die leitenden Verbindungen umgibt, **gekennzeichnet** durch folgende Verfahrensschritte,
- Aufbringen von elektronenstrahlhärtender Vergußmasse auf die leitenden Verbindungen sowie den integrierten Schaltkreis,
- Aushärten der elektronenstrahlhärtenden Vergußmasse mit einem Elektronenstrahl.

8. Verfahren gemaß Anspruch 7, dadurch **gekennzeichnet,** daß die elektronenstrahlhärtende Vergußmasse in eine vorher aufgesetzte elektronenstrahldurchlässige Gußform eingefüllt wird.

9. Vorrichtung zum Vergießen eines Moduls, bestehend aus Kontaktelementen, einem integrierten Schaltkreis, der leitend mit den Kontaktelementen verbunden ist, mit wenigstens einer Gußformhälfte mit einem Angußkanal, dadurch **gekennzeichnet,** daß die Gußform aus elektronenstrahldurchlässigem Material besteht, und im Bereich des Angußkanals elektronenstrahlabsorbierend ist.

10. Vorrichtung zum Vergießen eines Moduls, bestehend aus Kontaktelementen, einem integrierten Schaltkreis, der leitend mit den Kontaktelementen verbunden ist, mit wenigstens einer Gußformhälfte mit einem Angußkanal, dadurch **gekennzeichnet,** daß die Gußform aus UV-strahlendurchlässigen Material besteht, und im Bereich des Angußkanals UV-strahlenabsorbierend ist.
